# EUROPEAN PATENT APPLICATION

(11) **EP 4 016 841 A1**
(43) Date of publication of application: **22.06.2022**
(21) Application number: 20852149.2
(22) Date of filing: 24.04.2020
(51) Int. Cl.: H03H 9/02

(54) **RESONATOR HAVING COMPOSITE ANNULAR STRUCTURE, FILTER AND ELECTRONIC DEVICE**

(30) Priority: 15.08.2019 CN 201910754085
(71) Applicant: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); ZHANG, Menglun, Tianjin 300072 (CN)
(74) Representative: Meyer-Dulheuer MD Legal Patentanwälte PartG mbB
(86) International application number: PCT/CN2020/086557
(87) International publication number: WO 2021/027319

(57) **Abstract**

A bulk acoustic wave resonator, including: a substrate (110); an acoustic lens (120); a bottom electrode (130) that is disposed above the substrate (110); a top electrode (150) that is arranged opposite to the bottom electrode (130) and has an electrode connection part; and a piezoelectric layer (140) that is disposed above the bottom electrode (130) and between the bottom electrode (130) and the top electrode (150). An overlapping region of the acoustic lens (120), the bottom electrode (130), the piezoelectric layer (140) and the top electrode (150) in the thickness direction of the resonator constitutes an active region of the resonator. The edge of the top electrode (150) in the thickness direction of the resonator is provided with a composite annular structure which at least includes at least two annular structure layers. The at least two annular structure layers at least partially overlap at the interior of the active region in the thickness direction of the resonator, and at least one annular structure layer is a spatially discontinuous structure layer which is provided with a spatially discontinuous structure along the annular direction in the active region. The present invention further relates to a filter and an electronic device having the filter.

## Description

### TECHNICAL FIELD

Embodiments of the present disclosure relate to the field of semiconductors, and in particular, to a bulk acoustic wave resonator, a filter having the bulk acoustic wave resonator, and an electronic device having and the filter.

### BACKGROUND

A bulk acoustic wave filter has been widely used in current wireless communication systems due to low insertion loss, high square coefficient, high power capacity and the like, and becomes an important component for determining quality of radio frequency signals transmitted from or to the communication systems. Performance of the bulk acoustic wave filter is determined by a bulk acoustic wave resonator for forming the bulk acoustic wave filter. For example, a resonant frequency of the bulk acoustic wave resonator can determine an operation frequency of the filter, an effective electromechanical coupling coefficient of the bulk acoustic wave resonator can determine a bandwidth of the filter, and a quality factor of the bulk acoustic wave resonator can determine the insertion loss of the filter. When the filter has a predetermined structure, a quality factor thereof, especially the quality factor (or a series-parallel impedance) at a series resonant frequency and a parallel resonant frequency, significantly affects a passband insertion loss. Therefore, it is important to improve the quality factor of the resonator when designing the filter with high performance.

A quality factor (Qs) or impedance (Rs) at a series resonant frequency of the bulk acoustic wave resonator is usually determined by electrode loss and material loss, and a quality factor (Qp) or impedance (Rp) at a parallel resonant frequency of the bulk acoustic wave resonator is usually affected by boundary acoustic wave leakage. Therefore, when a material and an overlapping structure of the resonator are determined, improvement of Qs (or Rs) is limited. However, the boundary acoustic wave leakage can be effectively improved by changing a boundary structure of the resonator, thereby improving the Qp (or Rp) of the resonator.

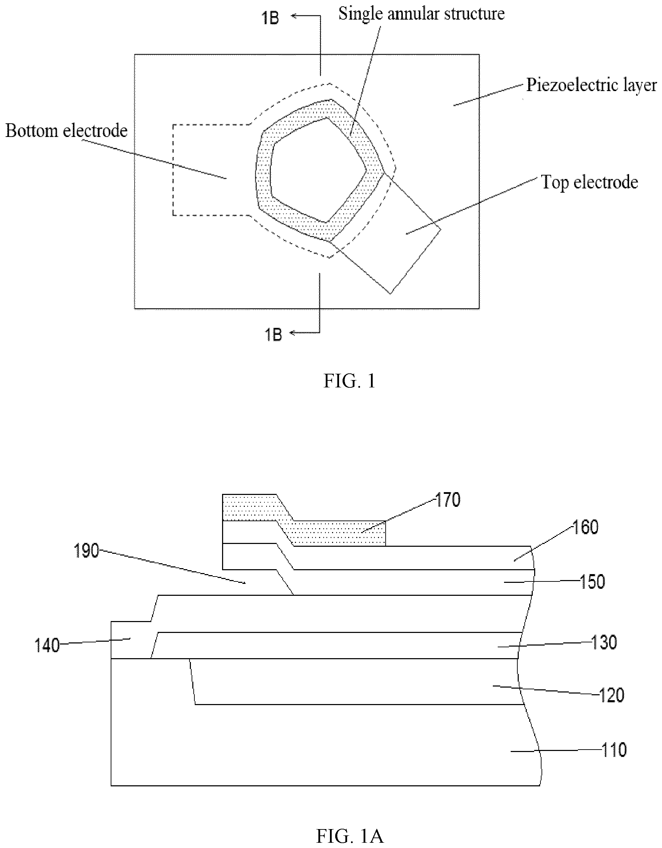

FIG. 1 is a schematic top view of a bulk acoustic wave resonator according to an exemplary embodiment in the related art, and FIG. 1A is a schematic partial sectional view of the bulk acoustic wave resonator along line 1B-1B according to an exemplary embodiment in the related art. As shown in FIGS. 1 and 1A, the bulk acoustic wave resonator includes a substrate 110, an acoustic mirror 120, a bottom electrode 130, a piezoelectric layer 140, a top electrode 150, a passivation layer 160, a wing 190, and a single annular structure 170. The acoustic mirror 120 is formed by a cavity embedded in the substrate, or may employ any other acoustic mirror structure such as a Bragg reflector. The bottom electrode 130 is deposited on an upper surface of the acoustic mirror and covers the acoustic mirror. As illustrated in FIGS. 1 and 1A, a single-layer annular structure 170 is arranged in a boundary structure of the resonator.

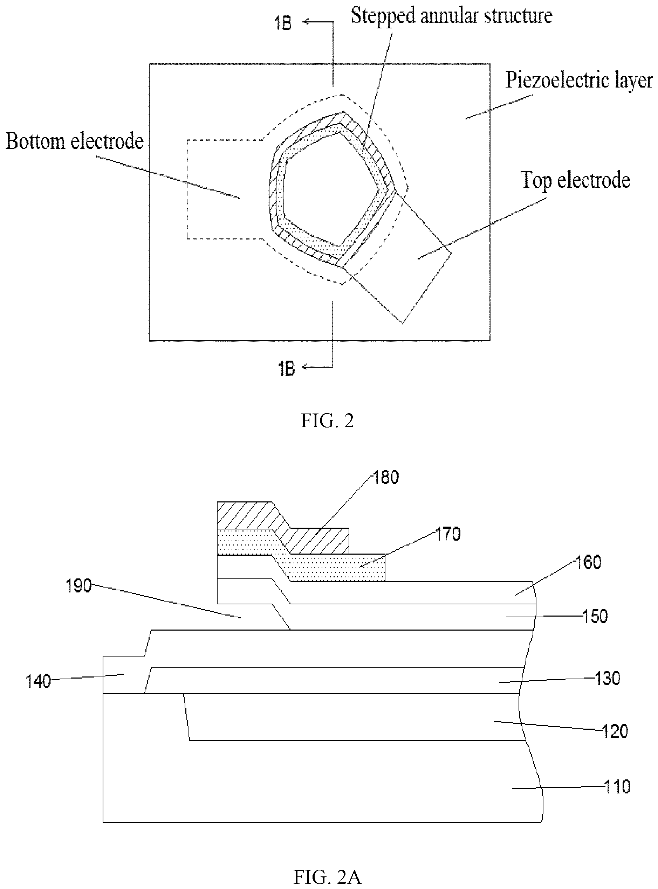

FIG. 2 is a schematic top view of a bulk acoustic wave resonator according to an exemplary embodiment in the related art, and FIG. 2A is a schematic partial sectional view of the bulk acoustic wave resonator along line 1B-1B in FIG. 1 according to an exemplary embodiment in the related art. As shown in FIGS. 2 and 2A, the bulk acoustic wave resonator includes a substrate 110, an acoustic mirror 120, a bottom electrode 130, a piezoelectric layer 140, a top electrode 150, a passivation layer 160, a wing 190, a bottom annular structure 170, and a top annular structure 180. The acoustic mirror 120 is formed by a cavity embedded in the substrate, or may employ any other acoustic mirror structure such as a Bragg reflector. The bottom annular structure 170 and the top annular structure 180 jointly constitute a composite annular structure. The bottom electrode 130 is deposited on an upper surface of the acoustic mirror and covers the acoustic mirror. As illustrated in FIGS. 2 and 2A, a boundary structure of the resonator is provided with the composite annular structure, which is formed by the bottom annular structure 170 and the top annular structure 180.

However, it is required to further improve the acoustic wave boundary leakage, thereby increasing the Qp (or Rp) of the resonator.

### SUMMARY

The present disclosure is provided in order to further improve a parallel resonance impedance value of a bulk acoustic wave resonator.

According to an aspect of embodiments of the present disclosure, there is provided a bulk acoustic wave resonator. The bulk acoustic wave resonator includes a substrate, an acoustic mirror, a bottom electrode provided above the substrate, a top electrode arranged opposite to the bottom electrode and having an electrode connection portion, and a piezoelectric layer provided above the bottom electrode and arranged between the bottom electrode and the top electrode. The acoustic mirror, the bottom electrode, the piezoelectric layer and the top electrode overlap with each other in a thickness direction of the resonator to form an overlapping region, which is an effective region of the resonator. A composite annular structure is provided on an edge of the top electrode in the thickness direction of the resonator. The composite annular structure includes at least two annular structure layers partially overlapping with each other at least in the effective region in the thickness direction of the resonator, at least one of the annular structure layers is a spatially discontinuous structure layer, and the spatially discontinuous structure layer is provided with a spatially discontinuous structure in an annular direction in the effective region.

Alternatively, the spatially discontinuous structure is an annular structure.

Alternatively, the resonator further includes a wing or bridge connected with the top electrode.

Alternatively, the spatially discontinuity structure is located only within the effective region in the thickness direction of the resonator, or the spatially discontinuous structure covers at least part of the wing or bridge in the thickness direction of the resonator.

Alternatively, the spatially discontinuous structure layer further includes an extending portion connected with the spatially discontinuous structure.

Alternatively, the extending portion covers at least part of the wing or bridge, or the extending portion covers the wing or bridge and extends beyond the wing or bridge.

Alternatively, an upper annular structure layer and a lower annular structure layer are arranged adjacent to each other in the thickness direction of the resonator.

Alternatively, an upper annular structure layer and a lower annular structure layer are spaced apart from each other in the thickness direction of the resonator.

Alternatively, the spatially discontinuous structure layers have a same thickness. Further alternatively, the spatially discontinuous structure is an integral structure. Alternatively, the integral structure includes a concave-convex structure. Alternatively, the concave-convex structure includes a serrated structure, a rectangular-slotted tooth-shaped structure, a wave-shaped structure, or a strip-shaped meandering structure.

Alternatively, the spatially discontinuous structure includes a plurality of strip-shaped structures spaced apart from each other in the annular direction and extending in parallel to each other.

Alternatively, different sections of the spatially discontinuous structure have thicknesses different from each other and alternately distributed in a high-low way along the annular direction. Further, the sections of the spatially discontinuous structure have a first thickness and a second thickness different from each other and alternately distributed in the annular direction.

According to another aspect of embodiments of the present disclosure, there is provided a filter including the bulk acoustic wave resonator as described above.

According to a further another aspect of embodiments of the present disclosure, there is provided an electronic device including the filter as described above or the bulk acoustic wave resonator as described above.

### BRIEF DESCRIPTION OF DRAWINGS

The following description and drawings can facilitate to understand these and other features and advantages in various embodiments disclosed in the present disclosure. The same reference signs in the drawings always indicate the same components, wherein:
FIG. 1 is a schematic top view of a bulk acoustic wave resonator according to an exemplary embodiment in the related art;
FIG. 1A is a schematic partial sectional view of the bulk acoustic wave resonator along line 1B-1B in FIG. 1 according to an exemplary embodiment in the related art;
FIG. 2 is a schematic top view of a bulk acoustic wave resonator according to an exemplary embodiment in the related art;
FIG. 2A is a schematic partial sectional view of the bulk acoustic wave resonator along line 1B-1B in FIG. 1 according to an exemplary embodiment in the related art;
FIG. 3 is a schematic top view of a bulk acoustic wave resonator according to an exemplary embodiment of the present disclosure;
FIG. 3A is a schematic sectional view along line 1B-1B in FIG. 3 according to an exemplary embodiment of the present disclosure;
FIG. 4 is a schematic partial perspective view of a bulk acoustic wave resonator according to an exemplary embodiment of the present disclosure;
FIG. 5 is a schematic partial perspective view of a bulk acoustic wave resonator according to an exemplary embodiment of the present disclosure;
FIG. 6 is a schematic partial perspective view of a bulk acoustic wave resonator according to an exemplary embodiment of the present disclosure;
FIG. 7 is a schematic partial perspective view of a bulk acoustic wave resonator according to an exemplary embodiment of the present disclosure;
FIG. 8 is a schematic partial perspective view of a bulk acoustic wave resonator according to an exemplary embodiment of the present disclosure;
FIG. 9 is a schematic partial perspective view of a bulk acoustic wave resonator according to an exemplary embodiment of the present disclosure;
FIG. 10 is a schematic partial perspective view of a bulk acoustic wave resonator according to an exemplary embodiment of the present disclosure;
FIG. 11 is a schematic partial perspective view of a bulk acoustic wave resonator according to an exemplary embodiment of the present disclosure; and
FIG. 12 is a schematic diagram of a frequency-impedance curve of a bulk acoustic wave resonator.

### DESCRIPTION OF EMBODIMENTS

The technical solutions of the present disclosure will be further described below in detail through embodiments and in conjunction with the drawings. The following description of embodiments of the present disclosure with reference to the drawings is intended to explain the general inventive concept of the present disclosure, and should not be construed as a limitation to the present disclosure.

A bulk acoustic wave resonator according to an embodiment of the present disclosure will be described below with reference to the drawings. It should be noted that, in the embodiments of the present disclosure, although a film bulk acoustic wave resonator is described as an example, these descriptions may be applied to other types of bulk acoustic wave resonators.

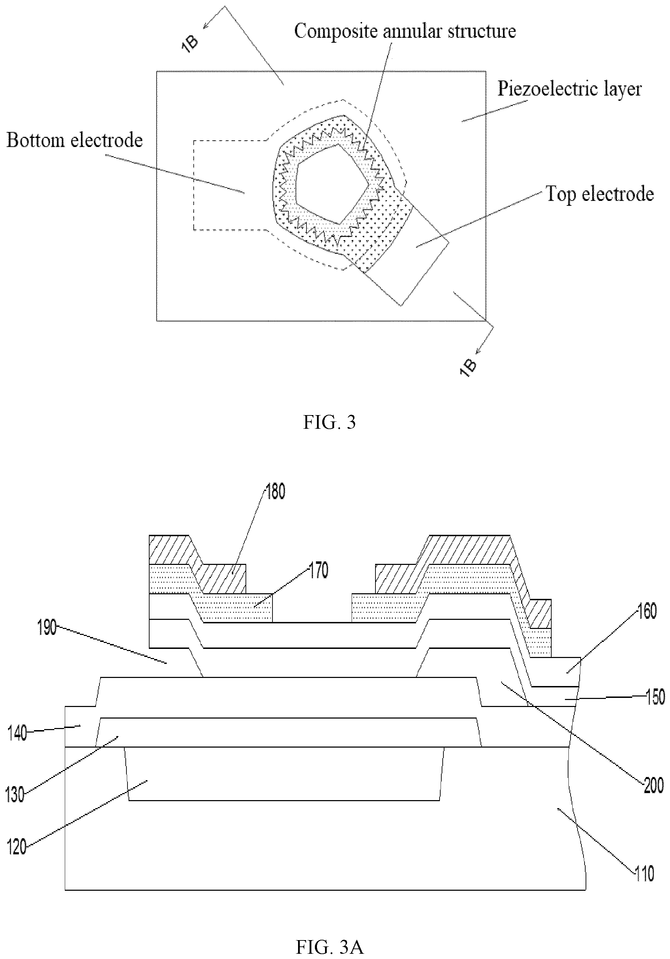

FIG. 3 is a top view of a bulk acoustic wave resonance structure of an embodiment. The bulk acoustic wave resonator includes a bottom electrode, a piezoelectric layer, a top electrode, and a composite annular structure.

FIG. 3A is a schematic partial sectional view of the bulk acoustic wave resonator along line 1B-1B in FIG. 3 according to an exemplary embodiment of the present disclosure. The bulk acoustic wave resonator includes a substrate 110 and an acoustic mirror 120 arranged on an upper surface of the substrate or embedded in an interior thereof. In FIG. 3A, the acoustic mirror is formed by a cavity embedded in the substrate, and any other acoustic mirror structure, such as a Bragg reflector, may be applicable. The bulk acoustic wave resonator further includes a bottom electrode 130, a piezoelectric layer 140, a top electrode 150, a passivation layer 160, a wing 190, a bridge 200, a bottom annular structure 170, and a top annular structure 180. The bottom annular structure 170 and the top annular structure 180 jointly form a composite annular structure. The bottom electrode 130 is deposited on an upper surface of the acoustic mirror and covers the acoustic mirror. An edge of the bottom electrode 130 may be etched into a bevel, and the bevel is located outside the acoustic mirror. Alternatively, the edge of the bottom electrode 130 may have a stepped structure or a vertical structure, or other similar structures. The bridge 200 spans a second end of the bottom electrode. Further, the bridge 200 has a first end inside the acoustic mirror and a second end outside the bottom electrode.

The acoustic mirror 120, the bottom electrode 130, the piezoelectric layer 140 and the top electrode 150 overlap with each other in a thickness direction of the resonator to form an overlapping region, which is an effective region of the resonator. As shown in FIG. 3A, the composite annular structure is located above the passivation layer 160. At the wing 190, the bottom annular structure 170 is located at an end of the top electrode and extends to an edge of the wing, and the top annular structure 180 is also located at the end of the top electrode and extends to the edge of the wing. At the bridge 200, the bottom annular structure 170 is located above the top electrode and has a first end located at an inner side of the bridge, and extends beyond the bridge. At the bridge 200, the top annular structure 180 is also located above the top electrode and has a first end located at the inner side of the bridge, and extends beyond the bridge.

Materials of components of the bulk acoustic wave resonator according to the present disclosure are exemplified below.

In the present disclosure, the electrode may be made of gold (Au), tungsten (W), molybdenum (Mo), platinum (Pt), ruthenium (Ru), iridium (Ir), titanium tungsten (TiW), aluminum (Al) , titanium (Ti), osmium (Os), magnesium (Mg), gold (Au), tungsten (W), molybdenum (Mo), platinum (Pt), ruthenium (Ru), iridium (Ir), germanium (Ge) , copper (Cu), aluminum (Al), chromium (Cr), arsenic-doped gold, and other similar metals.

In the present disclosure, the piezoelectric layer may be made of aluminum nitride (AlN), doped aluminum nitride (doped ALN), zinc oxide (ZnO), lead zirconate titanate (PZT), lithium niobate (LiNbO₃), quartz, potassium niobate (KNbO₃) or lithium tantalate (LiTaO₃), or other materials. The doped ALN contains at least one rare earth element, such as scandium (Sc), yttrium (Y), magnesium (Mg), titanium (Ti), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb), lutetium (Lu) and the like.

In the present disclosure, the substrate may be made of monocrystalline silicon (Si), gallium arsenide (GaAs), sapphire, quartz and the like. However, the substrate material is not limited thereto.

In the present disclosure, the passivation layer may be made of a dielectric material, which may be selected from, but not limited to, silicon dioxide (SiO₂), silicon nitride (Si₃N₄), silicon carbide (SiC), aluminum nitride (AlN), aluminum oxide (Al₂O₃) and the like.

It should be noted that the top annular structure 180 is not a regular structure and may have various stereoscopic structures.

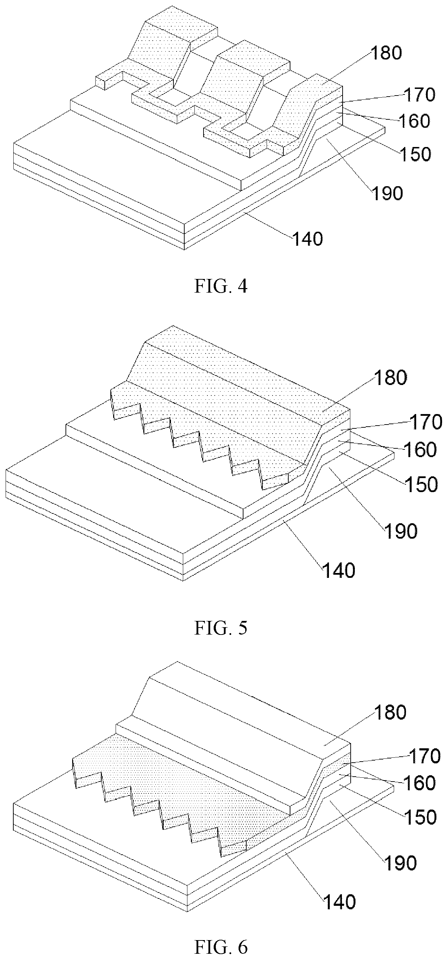

As shown in FIG. 4, the top annular structure 180 has a strip-shaped meander structure in the effective region. In addition, in FIG. 4, the top annular structure 180 has an extending portion extending to the edge of the wing and connected to the strip-shaped meander structure. As shown in FIG. 4, the extending portion may be formed by a plurality of sections, which are spaced apart from each other and connected to the strip-shaped meander structure at either side thereof.

In the present disclosure, the strip-shaped meander structure is formed by sequentially and alternately connecting a plurality of recesses and protrusions in a curved manner.

As shown in FIG. 5, a side edge of the top annular structure in the effective region has a serrated shape and extends to the edge of the wing. As shown in FIG. 5, the top annular structure includes a portion located within the effective region and having the serrated shape, and a portion completely covering the wing.

In FIGS. 4 and 5, the strip-shaped meander structure and the serrated structure form a spatially discontinuous structure.

It should be noted that in the present disclosure, the spatial discontinuity means in a top view of the resonator, a gap is formed in the effective region in a sectional view along an annular direction. The section may be an annular section parallel to the thickness direction of the resonator, or an annular section perpendicular to the thickness direction of the resonator.

It should also be noted that, in the present disclosure, the spatial discontinuity may be spatial discontinuity in an entire annular direction, or may be spatial discontinuity in a part of the annular direction.

In FIGS. 4 and 5, the spatially discontinuous structure is provided on the top annular structure. However, the spatially discontinuous structure may also be provided on the bottom annular structure.

As shown in FIG. 6, a side edge of the bottom annular structure in the effective region has a serrated shape, and the top annular structure has a regular structure. In Fig. 6, the serrated structure forms the spatially discontinuous structure.

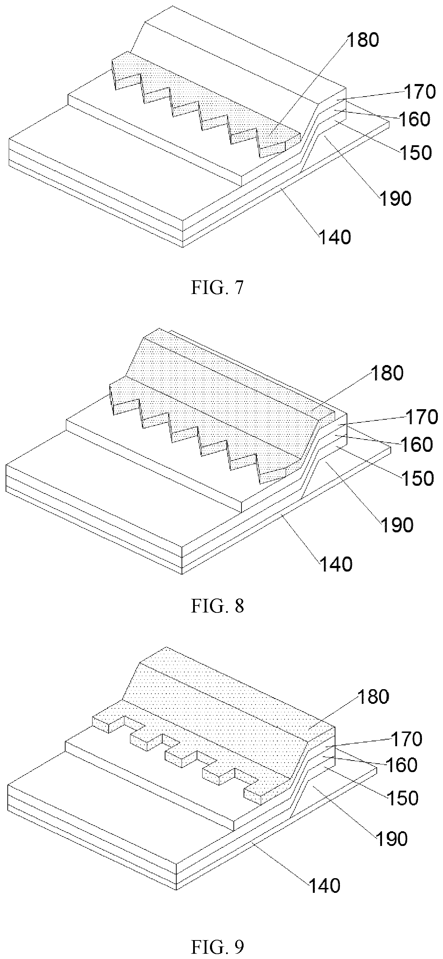

An embodiment shown in FIG. 7 is similar to that shown in FIG. 5 except that only the top annular structure is provided in the effective region.

An embodiment shown in FIG. 8 is similar to that shown in FIG. 5 except that the top annular structure only extends to a partial region of the wing, instead of covering the entire wing.

As shown in FIG. 9, at the bridge 200, a side edge of the top annular structure in the effective region has a serrated shape, and extends beyond the bridge. The top composite structure may be provided only in the effective region or partially cover the bridge.

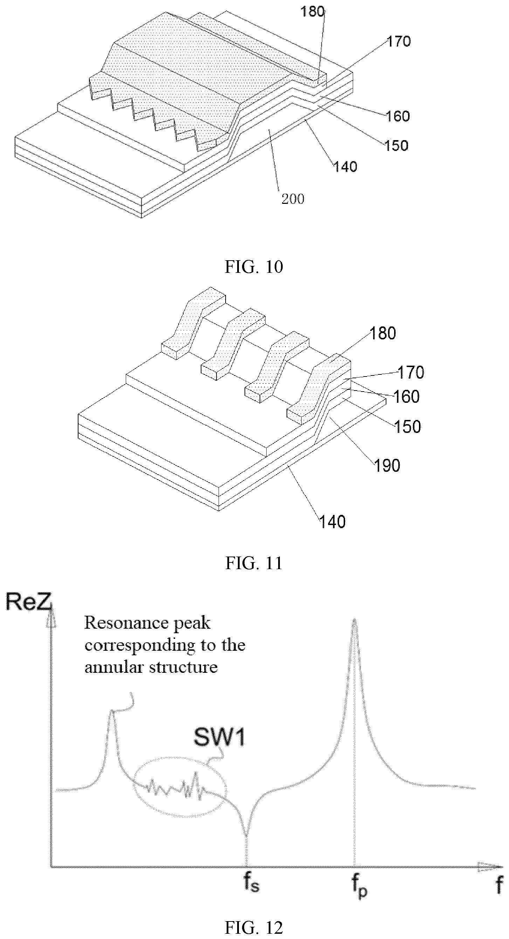

An embodiment shown in FIG. 10 is similar to that shown in FIG. 5 except that a side edge of the top annular structure in the effective region is in a protruding rectangular shape, and extends to the edge of the wing.

In the embodiment shown in FIG. 8, the top annular structure is not a continuous structure, and the top annular structure is in a discontinuous rectangular shape (which may be considered as a strip-shaped structure) in the effective region, and the rectangular shape extends to the edge of the wing. The discontinuous rectangle may be in other discontinuous shapes. In FIG. 11, the spatially discontinuous structure is a plurality of strip-shaped structures spaced apart from each other in the annular direction and extending in parallel.

In the above embodiments of the present disclosure, the spatially discontinuous structure is arranged above the passivation layer. It should be noted that the spatially discontinuous structure may be located above a covering layer such as the passivation layer, between the top electrode and the covering layer, between the piezoelectric layer and the top electrode, between the piezoelectric layer and the bottom electrode, or between the bottom electrode and the acoustic mirror.

In the illustrated embodiment of the present disclosure, the top annular structure and the bottom annular structure are adjacent to each other in the thickness direction of the resonator. However, the present disclosure is not limited thereto. Although not shown, the top annular structure and the bottom annular structure may be spaced apart from each other in the thickness direction of the resonator.

In the embodiments of the present disclosure, the composite annular structure has the top annular structure and the bottom annular structure. However, the present disclosure is not limited thereto. For example, the composite annular structure may include three or more layers of annular structures, as long as one or more of the layers may be spatially discontinuous layers. In addition, the composite annular structure may be made of a metal or a dielectric material, or combination thereof, such as molybdenum (Mo), gold (Au), platinum (Pt), aluminum nitride (AlN), silicon dioxide (SiO₂), silicon nitride (Si₃N₄), doped AIN or the like.

In the above embodiments, the spatially discontinuous structures (layers) may have the same thickness. The spatial discontinuity may be formed by a gap or space formed in the annular direction, and the gap or the space is formed in the annular section parallel to the thickness direction of the resonator.

However, the present disclosure is not limited to the above. The spatial discontinuity may be formed by change in the thickness of the spatially discontinuous structure in the thickness direction of the resonator, and the gap or space may be formed in the annular section perpendicular to the thickness direction of the resonator. In this case, different parts of the spatially discontinuous structure have different thicknesses from each other, and the thicknesses have a high-low distribution in the annular direction. Specifically, the different parts of the spatially discontinuous structure may have a first thickness and a second thickness, which are different from each other and alternately distributed in the annular direction. When the first thickness is less than the second thickness, the first thickness may be zero or lower (with respect to a recessed surface).

In the present disclosure, the spatially discontinuous structure leads to high-low impedance transformation in a radial direction of the resonator and high-low impedance transformation in a circumferential or annular direction of the resonator. Therefore, a Lamb wave propagating in a plane along any direction can be effectively reflected, so as to confine more acoustic energy in the effective region and further enhance an acoustic wave reflection and conversion capability of the annular structure. Accordingly, a piston acoustic wave mode perpendicular to a surface of the piezoelectric layer is further improved, thereby enhancing electrical performance of the resonator, i.e., effectively improving the parallel resonance impedance Rp.

Compared with traditional single-layer annular structure and stepped annular structure, the bulk acoustic wave resonator of the present disclosure has the spatially discontinuous arrangement in the effective region and the spatial discontinuity forms a corresponding high and low acoustic impedance transformation, thereby forming a lateral Bragg reflection layer at the boundary. Therefore, more Lamb wave energy propagating along an edge of the resonator can be confined, thereby further increasing the parallel resonance impedance Rp. Furthermore, for the traditional single-layer annular structure or the stepped annular structure, the annular structure portion may be equivalent to a resonator having a frequency lower than a frequency of a main resonator. When the annular structure has a larger width, a total area of the annular structure is increased so that an obvious resonance peak is formed below the series resonance frequency. As shown in FIG. 12, this resonance peak would affect the out-of-band suppression or duplexer matching effect in a filter. Hence, it is desired to minimize this resonance peak. However, in the resonator annular structure of the present disclosure, the annular structure can be divided into several sections with smaller areas in the circumferential direction of the resonator to reduce an area of the equivalent resonance region of the annular structure, thereby reducing the resonance effect due to the annular structure.

In view of the above description, the present disclosure provides the following technical solutions.
1. A bulk acoustic wave resonator includes:
   a substrate;
   an acoustic mirror;
   a bottom electrode provided above the substrate;
   a top electrode arranged opposite to the bottom electrode and having an electrode connection portion; and
   a piezoelectric layer provided above the bottom electrode and arranged between the bottom electrode and the top electrode,
   wherein:
      the acoustic mirror, the bottom electrode, the piezoelectric layer and the top electrode overlap with each other in a thickness direction of the resonator to form an overlapping region, which is an effective region of the resonator; and
      a composite annular structure is provided on an edge of the top electrode in the thickness direction of the resonator, the composite annular structure includes at least two annular structure layers partially overlapping with each other at least in the effective region in the thickness direction of the resonator, at least one of the annular structure layers is a spatially discontinuous structure layer, and the spatially discontinuous structure layer is provided with a spatially discontinuous structure in an annular direction in the effective region.
2. The resonator according to 1, wherein the spatially discontinuous structure is an annular structure.
3. The resonator according to 1 or 2, further includes a wing or a bridge connected to the top electrode.
4. The resonator according to 3, wherein:
   the spatially discontinuity structure is located only within the effective region in the thickness direction of the resonator; or
   the spatially discontinuous structure covers at least part of the wing or the bridge in the thickness direction of the resonator.
5. The resonator according to 4, wherein the spatially discontinuous structure layer further includes an extending portion connected with the spatially discontinuous structure.
6. The resonator according to 5, wherein the extending portion covers at least part of the wing or the bridge, or the extending portion covers the wing or the bridge and extends beyond the wing or the bridge.
7. The resonator of any one of 1 to 6, wherein an upper annular structure layer and a lower annular structure layer are arranged adjacent to each other in the thickness direction of the resonator.
8. The resonator of any one of 1 to 6, wherein an upper annular structure layer and a lower annular structure layer are spaced apart from each other in the thickness direction of the resonator.
9. The resonator of any one of 1 to 8, wherein the spatially discontinuous structure layers have a same thickness.
10. The resonator of any one of 1 to 9, wherein the spatially discontinuous structure is an integral structure.
11. The resonator of 10, wherein the integral structure includes a concave-convex structure.
12. The resonator of 11, wherein the concave-convex structure includes a serrated structure, a rectangular-slotted tooth-shaped structure, a wave-shaped structure, or a strip-shaped meander structure.
13. The resonator of 9, wherein the spatially discontinuous structure includes a plurality of strip-shaped structures spaced apart from each other in the annular direction and extending in parallel to each other.
14. The resonator of any one of 1 to 8, wherein the spatially discontinuous structure has different sections which have a first thicknesses and a second thicknesses different from each other and alternately distributed in the annular direction.
15. The resonator according to 1, wherein:
   the resonator has a covering layer; and
   the spatially discontinuous structure layer is located above the covering layer, between the top electrode and the covering layer, between the piezoelectric layer and the top electrode, between the piezoelectric layer and the bottom electrode, or between the bottom electrode and the acoustic mirror.

In view of the above, the present disclosure also provides a filter including a plurality of bulk acoustic wave resonators as described above. The present disclosure also provides an electronic device including the filter or the bulk acoustic wave resonator as described above.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator, comprising:
a substrate;
an acoustic mirror;
a bottom electrode provided above the substrate;
a top electrode arranged opposite to the bottom electrode and having an electrode connection portion; and
a piezoelectric layer provided above the bottom electrode and arranged between the bottom electrode and the top electrode,
wherein the acoustic mirror, the bottom electrode, the piezoelectric layer and the top electrode overlap with each other in a thickness direction of the resonator to form an overlapping region, and the overlapping region is an effective region of the resonator; and
wherein a composite annular structure is provided on an edge of the top electrode in the thickness direction of the resonator, the composite annular structure comprises at least two annular structure layers partially overlapping with each other at least in the effective region in the thickness direction of the resonator, at least one of the annular structure layers is a spatially discontinuous structure layer, and the spatially discontinuous structure layer is provided with a spatially discontinuous structure in an annular direction in the effective region.

2. The resonator according to claim 1, **characterized in that** the spatially discontinuous structure is an annular structure.

3. The resonator according to claim 1 or 2, **characterized in that** the resonator further comprises a wing or bridge connected with the top electrode.

4. The resonator according to claim 3, **characterized in that** the spatially discontinuity structure is located only within the effective region in the thickness direction of the resonator; or
the spatially discontinuous structure covers at least part of the wing or bridge in the thickness direction of the resonator.

5. The resonator according to claim 4, **characterized in that** the spatially discontinuous structure layer further comprises an extending portion connected with the spatially discontinuous structure.

6. The resonator according to claim 5, **characterized in that** the extending portion covers at least part of the wing or bridge, or the extending portion covers the wing or bridge and extends beyond the wing or bridge.

7. The resonator of any one of claims 1 to 6, **characterized in that** an upper annular structure layer and a lower annular structure layer are arranged adjacent to each other in the thickness direction of the resonator.

8. The resonator according to any one of claims 1 to 6, wherein an upper annular structure layer and a lower annular structure layer are spaced apart from each other in the thickness direction of the resonator.

9. The resonator according to any one of claims 1 to 8, **characterized in that** the spatially discontinuous structure layers have a same thickness.

10. The resonator according to any one of claims 1 to 9, **characterized in that** the spatially discontinuous structure is an integral structure.

11. The resonator according to claim 10, **characterized in that** the integral structure comprises a concave-convex structure.

12. The resonator according to claim 11, **characterized in that** the concave-convex structure comprises a serrated structure, a rectangular-slotted tooth-shaped structure, a wave-shaped structure, or a strip-shaped meandering structure.

13. The resonator according to claim 9, **characterized in that** the spatially discontinuous structure comprises a plurality of strip-shaped structures spaced apart from each other in the annular direction and extending in parallel to each other.

14. The resonator according to any one of claims 1 to 8, **characterized in that** different sections of the spatially discontinuous structure have thicknesses different from each other and alternately distributed in a high-low way along the annular direction.

15. The resonator according to claim 14, **characterized in that** the different sections of the spatially discontinuous structure have a first thickness and a second thickness, and the first thickness and the second thickness are different from each other and alternately distributed in the annular direction.

16. The resonator according to claim 1, **characterized in that** the resonator is provided with a covering layer; and
the spatially discontinuous structure layer is located above the covering layer, between the top electrode and the covering layer, between the piezoelectric layer and the top electrode, between the piezoelectric layer and the bottom electrode, or between the bottom electrode and the acoustic mirror.

17. A filter, comprising the bulk acoustic wave resonator according to any one of claims 1 to 16.

18. An electronic device, comprising the filter according to claim 17 or the bulk acoustic wave resonator according to any one of claims 1 to 16.
